# EUROPÄISCHE PATENTANMELDUNG

(11) **EP 4 431 578 A1**
(43) Veröffentlichungstag der Anmeldung: **18.09.2024**
(21) Anmeldenummer: 24175359.9
(22) Anmeldetag: 24.03.2020
(51) Int. Cl.: C09J 9/02, H01B 1/22, H01B 1/02, C08K 9/08

(54) **MEHRKOMPONENTENSYSTEM UND VERFAHREN ZUR HERSTELLUNG EINES MEHRKOMPONENTENSYSTEMS**

(30) Priorität: 25.03.2019 DE 102019107633
(62) Teilanmeldung aus: 20717101.8
(71) Anmelder: COSA Group GmbH, 80333 München (DE)
(72) Erfinder: POTRECK, Janine-Melanie, 80686 München (DE)
(74) Vertreter: Maiwald GmbH

(57) **Zusammenfassung**

Mehrkomponentensystem mit wenigstens einem ersten Stoff und mit wenigstens einem zweiten Stoff, wobei das Mehrkomponentensystem aktivierbar ist, wobei der erste Stoff und der zweite Stoff in mehreren Stoffportionen vorliegt, wobei die ersten Stoffportionen mit wenigstens einer ersten funktionellen Gruppe (R2) ausgebildet und einem ersten Linker (L1) versehen sind und wobei die zweiten Stoffportionen mit wenigstens einer zweiten funktionellen Gruppe (R21) ausgebildet und einem zweiten Linker (L2) versehen sind, wobei die erste funktionelle Gruppe (R2) über eine vordefinierte Wechselwirkung mit der zweiten funktionellen Gruppe (R21) reagiert und diese miteinander verbindet und wobei der Abstand der funktionellen Gruppen zu der jeweiligen Stoffportion durch den jeweiligen Linker (L) bestimmt ist.

## Beschreibung

Die vorliegende Erfindung betrifft ein Mehrkomponentensystem sowie ein Verfahren zur Herstellung eines Mehrkomponentensystems.

Aus dem Stand der Technik sind bereits Mehrkomponentensysteme bekannt.

Beispielsweise werden in der Klebetechnik Mehrkomponentensystem eingesetzt, wie beispielsweise Zweikomponentensysteme.

Hier werden beispielsweise spezielle Handapplikatoren wie in der DE 202017000446 U1 genutzt, um das Klebesystem zu aktivieren und dann auftragen zu können.

Aus der US 2012/0107601 A1 ist weiter bereits ein Kapselsystem bekannt, dass auf Druck reagiert und Flüssigkeiten entsprechend freisetzt.

Weitere Kapselsysteme sind beispielsweise aus der WO 2017/192407 A1, der US 8,747,999 B2, der WO 2017 042709 A1, der WO 2016/049308 A1 und der WO 2018/028058 A1 bekannt.

Kapsel-in-Kapsel-Systeme sind weiter aus z.B. der US 9,637,611 B2, der WO 2002/060573 A2 oder der US 4,891,172 A bekannt.

Bisherige Kapselsysteme sind durchweg passive Systeme. Damit ist gemeint, dass diese eine oder mehrere Kapseln aufweisen und die interessierende Komponente in der bzw. den Kapsel/n eingeschlossen wird. Zu einem definierten Zeitpunkt, auch Aktivierung genannt, wird dann dieser Inhalt der Kapsel entleert und dadurch die Komponente entsprechend freigesetzt.

Wünschenswert wäre es jedoch, die Freisetzung der Komponenten und deren Durchmischung besser steuern zu können.

Es ist die Aufgabe der vorliegenden Erfindung, ein Mehrkomponentensystem sowie ein Verfahren zur Herstellung eines Mehrkomponentensystems der eingangs genannten Art in vorteilhafter Weise weiterzubilden, insbesondere dahingehend, dass die Dosierung von einzelnen Komponenten von Mehrkomponentensystemen und deren Durchmischung besser gesteuert werden kann, um somit die Effizienz der Reaktion des Mehrkomponentensystems zu verbessern.

Diese Aufgabe wird erfindungsgemäß gelöst durch ein Mehrkomponentensystem mit den Merkmalen des Anspruchs 1. Danach ist vorgesehen, dass ein Mehrkomponentensystem bereitgestellt wird, mit wenigstens einem ersten Stoff und mit wenigstens einem zweiten Stoff, wobei das Mehrkomponentensystem aktivierbar ist, wobei der erste Stoff und der zweite Stoff in mehreren Stoffportionen vorliegt, wobei die ersten Stoffportionen mit wenigstens einer ersten funktionellen Gruppe ausgebildet und einem ersten Linker versehen sind und wobei die zweiten Stoffportionen mit wenigstens einer zweiten funktionellen Gruppe ausgebildet und einem zweiten Linker versehen sind, wobei die erste funktionelle Gruppe über eine vordefinierte Wechselwirkung über schwache oder starke Wechselwirkung, bevorzugt aber über kovalente Bindung mit der zweiten funktionellen Gruppe reagiert und diese miteinander verbindet und wobei der Abstand der funktionellen Gruppen zu der jeweiligen Stoffportion durch den jeweiligen Linker bestimmt ist.

Die Erfindung basiert auf dem Grundgedanken, dass durch definierte räumliche Anordnung mit Hilfe der Linker und der Verbindung durch die funktionellen Gruppen wenigstens ein erster Stoff und wenigstens ein zweiter Stoff definiert zueinander angeordnet werden. Somit wird es nun möglich, den ersten Stoff und den zweiten Stoff in einem definierten Verhältnis und entsprechend definiertem Abstand getrennt voneinander anzuordnen. Durch entsprechende Aktivierung werden dann die Stoffe miteinander vermischt und die Reaktion der Stoffe miteinander ermöglicht.

Denkbar ist grundsätzlich auch, dass der erste und der zweite Stoff identisch sind, so dass an sich ein Ein-Komponentensystem vorliegt. Auch derartige Systeme sollen als Mehrkomponentensysteme im vorstehenden Sinne verstanden werden.

Des Weiteren kann vorgesehen sein, dass der erste Linker länger als der zweite Linker ist oder umgekehrt. Hierdurch ergibt sich der Vorteil, dass beispielsweise die ersten Stoffe nach entsprechender Bindung einen größeren Abstand zueinander einnehmen als der erste Stoff zum zweiten Stoff. Dies führt dazu, dass der zweite Stoff immer räumlich zwischen den ersten Stoffen angeordnet ist, was die Durchmischung begünstigt. Auch eine Einstellung der Konzentrations- und/oder Volumenverhältnisse der Stoffe relativ zueinander wird hierdurch begünstigt.

Ein Linker kann jede Form von Verbindung zwischen einer Kapsel und einer funktionellen Gruppe sein.

Ein Linker kann auch jede Art der direkten Verbindung zwischen einer Kapsel und einer funktionellen Gruppe sein.

Außerdem ist denkbar, dass die ersten Stoffportionen und die zweiten Stoffportionen sich dahingehend unterscheiden, dass die ersten Stoffportionen mit einer größeren Anzahl an Stoffportionen verbunden sind bzw. verbindbar sind als die zweiten Stoffportionen oder umgekehrt. Hierdurch lässt sich das Konzentrations- und/oder Volumenverhältnis und das relative Verhältnis der Stoffe zueinander einstellen.

Die funktionellen Gruppen können homogen oder heterogen ausgebildet sein. Denkbar ist beispielsweise, dass ein Stoff und die zugehörigen funktionellen Gruppen heterogen sind, d.h. dass unterschiedliche funktionelle Gruppen eingesetzt werden können. Dies ist beispielsweise dann wünschenswert, wenn man erreichen möchte, dass z.B. bei der Herstellung bestimmte Linker zunächst mit Schutzgruppen versehen werden und für bestimmte Bindungen verwendet werden sollen, beispielsweise erster Stoff zu erster Stoff oder zweiter Stoff zu zweiter Stoff oder auch erster Stoff zu zweiter Stoff. Denkbar ist auch, dass eine erste funktionelle Gruppe eine Verbindung von zwei Kapseln ermöglicht, und eine zweite, unterschiedliche funktionelle Gruppe die Bindung von Kapseln auf Oberflächen oder Fasern ermöglicht. Denkbar ist auch, dass eine erste funktionelle Gruppe eine Bindung von zwei Kapseln ermöglicht, und eine zweite, unterschiedliche funktionelle Gruppe es ermöglicht, die Eigenschaften der Kapseln zu verändern, z.B. Biokompartibilität, Löslichkeit, oder ähnliche Eigenschaften. Denkbar ist auch, dass heterogene funktionelle Gruppen es ermöglichen, ein Drei-oder Mehrkomponentensystem auszugestalten.

Denkbar ist aber auch, dass alle funktionellen Gruppen homogen, d.h. identisch ausgebildet sind. Bei heterogener Ausbildung ist auch denkbar, dass dies mit weiteren Eigenschaften bzw. Unterschieden in der Ausgestaltung der Linker (z.B. Länge, Winkel, Art des Linkers usw.) kombiniert wird.

Die ersten Stoffportionen können eine im Wesentlichen identische Größe aufweisen und/oder die zweiten Stoffportionen eine im Wesentlichen identische Größe aufweisen. Mit Größe kann insbesondere die räumliche Ausdehnung, aber auch die Masse bzw. das eingenommene Volumen gemeint sein. Denkbar ist, dass die ersten Stoffportionen und die zweiten Stoffportionen jeweils eine identische Größe bzw. Menge aufweisen.

Insbesondere ist aber auch denkbar, dass die ersten Stoffportionen und die zweiten Stoffportionen eine unterschiedliche Größe aufweisen.

Durch die Wahl der Größe wird auch das jeweilige (lokale) Volumen und/oder die jeweilige lokale Konzentration des jeweiligen Stoffes bestimmt.

Das Mehrkomponentensystem kann eine Netzwerkstruktur mit Zwischenräumen aufweisen, wobei die Netzwerkstruktur von Stoffportionen des ersten Stoffes ausgebildet ist, wobei in den Zwischenräumen ein Umgebungsmedium und zumindest abschnittsweise je wenigstens eine Stoffportion des zweiten Stoffes angeordnet ist. Eine verbesserte Durchmischung der einzelnen Stoffe und somit auch ein verbesserten Materialeinsatz sind die Folge.

Des Weiteren kann vorgesehen sein, dass eine Stoffportion des ersten Stoffes und/oder des zweiten Stoffes in einer Kapsel, insbesondere einer Nanokapsel und/oder Mikrokapsel angeordnet ist. Durch die Kapselung wird es einfach möglich, eine definierte Masse bzw. ein definiertes Volumen des ersten und/oder zweiten Stoffes für das Mehrkomponentensystem bereitstellen zu können. Bei einem Mehrkapselsystem bzw. z.B. einem Zweikomponenten-Kapselsystem (2K-Kapselsystem) ist es möglich, das die Kapselinhalte in einer definierten Anzahl und/oder einem definierten Verhältnis und Abstand in getrennten Räumen miteinander gebunden sind, bis die Kapseln aktiviert werden und somit deren Inhalte miteinander reagieren können bzw. gezwungen werden, miteinander zu reagieren, bzw. sich zu vermischen, wenn die Kapseln den selben Inhalt aufweisen. Je Kapsel ist eine Stoffportion eines Stoffes angeordnet bzw. abgepackt. Denkbar wäre auch, dass eine Kapsel mehrere Stoffportionen enthält. Eine Anordnung von Kapseln mit ersten Stoffen und zweiten Stoffen kann auch als Kapselkomplex bezeichnet werden und hat in etwa eine Funktion wie ein (Mini-)Reaktionskolben, in dem die Reagenzien nach Aktivierung zu einem definierten Zeitpunkt miteinander vermischt und die Reaktion der Stoffe miteinander in Gang gesetzt wird. Durch die große Anzahl dieser Kapselkomplexe wird die Wirkweise aufsummiert und es kommt zu einem größeren Effekt bzw. wird die Vermischung und Reaktion der Stoffe verbessert. Weitere Vorteil ergeben sich durch die bessere Durchmischung der einzelnen Stoffe bzw. Reaktionsbestandteile miteinander und somit kann - verglichen mit bisherigen Systemen - ein höherer Umsatz bei gleichzeitig geringerem Materialeinsatz erreicht werden. Bei einem Einkomponentensystem kann die Durchmischung deutlich verbessert werden. Insbesondere bei hochviskosen Klebebändern kann so mit einem Einkomponentenklebstoff eine vollständige Vernetzung durch das Klebeband erreicht werden.

Insbesondere kann vorgesehen sein, dass eine Kapsel für den ersten Stoff eine andere Größe aufweist als eine Kapsel für den zweiten Stoff, insbesondere wobei die Kapsel für den ersten Stoff größer ist als die Kapsel für den zweiten Stoff. Hierdurch erfolgt eine Einstellung des Verhältnisses der Volumina des ersten Stoffes in Relation zum zweiten Stoff (oder umgekehrt) und auch eine Einstellung des Aktivierungsverhaltens.

Denkbar ist weiter, dass die Kapseln für den ersten Stoff eine identische Größe aufweisen. Auch dies dient der Einstellung des Aktivierungsverhaltens.

Denkbar ist, dass die Aktivierung der Kapseln des Mehrkomponentensystems durch wenigstens eine Änderung von Druck, pH-Wert, UV-Strahlung, Osmose, Temperatur, Lichtintensität, Feuchtigkeit oder dergleichen erfolgt.

Denkbar ist einen oder mehrere Aktivierungsmechanismen parallel zu nutzen.

Mögliche Kapseltypen umfassen beispielsweise Doppelkapseln, Multikernkapseln Kapseln mit kationischen oder anionischem Charakter, Kapseln mit unterschiedlichem Hüllmaterial, Kapseln mit mehreren Hüllen, Kapseln mit mehreren Schichten des Hüllenmaterials (sogenannte Multilayer microcapsules), Kapseln mit Metallnanopartikeln, Matrixkapseln und/oder Hohlkapseln, Kapseln mit einem dichten Hüllmaterial, z.B. einem absolut dichten Hüllmaterial, poröse Kapseln und/oder leere poröse Kapseln (beispielsweise um Gerüche einzukapseln).

Der erste Stoff und der zweite Stoff können Bestandteile eines MehrKomponentenklebstoffes, insbesondere Zweikomponenten-Klebstoffes, sein.

Grundsätzlich sind auch andere Anwendungsfelder möglich.

Insbesondere kann vorgesehen sein, dass der erste Stoff und der zweite Stoff Bestandteile eines Einkomponenten-Klebstoffes sind. In anderen Worten, der erste Stoff und der zweite Stoff können derselbe Stoff sein.

Die Kapseln sind mit Linkern und mit funktionellen Gruppen ausgebildet bzw. funktionalisiert. Die Linker sollen die Kapseln untereinander vernetzen. Es kann vorgesehen sein, dass die funktionellen Gruppen noch mit einer Schutzgruppe versehen sind. Der Abstand der Kapseln kann durch die Länge der Linker bestimmt werden. Die Länge der Linker ist so zu wählen, dass der Radius des Inhaltes der entleerten Flüssigkeit der Kapseln sich mit dem Inhalt der Nachbarkapseln leicht überschneidet, um eine Vernetzung zu gewährleisten. Bei einem höher viskosen Umgebungsmedium (wie z.B. einem Klebeband) wären die Länge der Linker kleiner zu wählen als bei einem niedrig viskoseren Medium wie eine Paste oder Flüssigkeit.

Generell ist eine Intravernetzung von Kapseln möglich. Hier werden Kapseln einer Kapselpopulation miteinander vernetzt.

Generell ist es möglich, dass über Intravernetzung Kapseln mit demselben Inhalt vernetzt werden.

Generell ist alternativ oder zusätzlich eine Intervernetzung von Kapseln möglich. Hier werden Kapseln von mindestens zwei unterschiedlichen Kapselpopulationen miteinander vernetzt.

Generell ist es möglich, dass über Intervernetzung Kapseln mit unterschiedlichen Inhalten vernetzt werden.

Es ist denkbar, dass bei chemisch härtenden Klebstoffen Harz und Härter in dem Zweikomponentensystem mit zwei getrennten Reaktionsräumen in einem definierten Volumenverhältnis in getrennten Kapseln vorliegen und gegen die Aktivierungsreaktionen bei Lagerbedingungen geschützt sind. Durch z.B. Änderung von Druck, pH-Wert, UV-Strahlung, Osmose, Temperatur, Lichtintensität, Feuchtigkeit oder den Ausschluss von Luft wird dann die Aushärtereaktion ausgelöst.

Die Kapseln eines Einkomponenten-Kapselsystems oder Mehrkomponenten-Kapselsystems, z.B. eines Zweikomponenten-Kapselsystems können in die Gasphase, in pastöses Medium, in visköses Medium, in hoch-visköses Medium, in flüssige Systeme eingebracht und/oder auf feste Oberflächen gebracht werden.

Denkbar ist beispielsweise, dass die Kapseln in einem Spray (Sprühklebstoff) enthalten sind.

Es ist denkbar, dass ein Mehrkomponentensystem z.B. ein Zweikomponenten-Klebstoff in einem pastösen Medium als Umgebungsmedium eingearbeitet ist. Damit kann ermöglicht werden, den Klebstoff sehr präzise auf eine zu verklebende Fläche, beispielsweise eine Oberfläche aufzutragen. Der Zweikomponentenklebstoff wäre bis zur Aktivierung noch nicht aktiviert, die Prozesszeit, sowie die Aktivierung kann individuell bestimmt werden.

Es ist denkbar, dass die Kapseln auf einer Oberfläche z.B. einem Trägermaterial angebracht sind. Die Kapseln können beispielsweise in und/oder auf einem doppel-oder einseitigen Trägermaterial enthalten sein. Das Trägermaterial kann beispielsweise ein Kunststoff, eine Kunststofffolie oder ein Metall oder eine Metallfolie oder ein Kunststoffschaum oder ein Textilgewebe oder ein Papier umfassen. Möglich ist auch, dass das Trägermaterial weiterbearbeitet wird, zum Beispiel durch Bedrucken oder Stanzen, oder auch anderweitig.

Eine Anwendungsmöglichkeit eines doppel-oder einseitigen Trägermaterials umfassend die Kapseln eines Einkomponenten-Kapselsystems oder Mehrkomponenten-Kapselsystems, z.B. eines Zweikomponenten-Kapselsystems ist ein Klebeband und/oder Klebestreifen und/oder Klebeetikett.

Eine Anwendungsmöglichkeit eines doppel-oder einseitigen Trägermaterials beinhaltend die Kapseln eines Einkomponenten-Kapselsystems oder Mehrkomponenten-Kapselsystems, z.B. eines Zweikomponenten-Kapselsystems ist ein Klebeband und/oder Klebestreifen und/oder Klebeetikett zur Wundabdeckung bei Menschen oder Tieren. Auch eine Anwendung bei Pflanzen, z.B. bei Bäumen, ist generell möglich. Das Trägermaterial kann z.B. auf die Haut und/oder Körperoberfläche des Menschen oder Tieres oder der Pflanze angebracht werden. Möglich ist auch, dass das Trägermaterial im (Körper-)Inneren des Menschen oder Tieres oder der Pflanze angebracht wird.

Insbesondere kann so eine Wundabdeckung bei Menschen, Tieren oder Pflanzen ermöglicht werden. Möglich ist, dass Wunden gezielt verklebt werden. Danach ist vorgesehen, dass ein Haftkleber auf einem doppel-oder einseitigen Trägermaterial eine erste Haftung zur Positionierung des Trägermaterials ermöglicht. Über die Aktivierung der Kapseln findet eine Vernetzung statt, die eine finale Haftung ermöglicht. Alternativ oder zusätzlich kann so die Wiederherstellung eines Gewebes, z.B. von Knochen und/oder Knorpelgewebe, Nervengewebe, Muskelgewebe, Fettgewebe, Epithelgewebe, Enamel, Dentin, Pulpa, Parenchym, Kellenchym, Sklerencym, Epidermis, Periderm, Xylem, Phloem oder Organes, welches z.B. durch Unfall, Verletzung, operativen Eingriff oder eine andere Art der Schädigung strukturell und/oder funktionell verändert wurde, durch die Anbringung eines doppel-oder einseitigen Trägermaterials von Ein-oder Mehrkomponenten-Klebstoffen ermöglicht werden.

Es ist denkbar, dass eine zu verklebende Oberfläche mit einer funktionellen Gruppe ausgebildet bzw. versehen wird (also funktionalisiert wird), die zu einer funktionellen Gruppe, mit welcher Zweikomponenten-Mikrokapseln funktionalisiert wurden, komplementär ist. Die Zweikomponenten-Mikrokapseln können auf die zu verklebende Oberfläche gebunden werden. Die zu verklebende Oberfläche kann somit nicht klebrig ausgebildet sein. Der Zeitpunkt, sowie die Art der Aktivierung der Zweikomponenten-Mikrokapseln kann exakt bestimmt werden. Dies kann beispielsweise Anwendung beim Kleben im Mikrobereich finden, wie z.B. beim Verkleben von Elektronik, Displays oder Ähnlichem. Denkbar ist auch eine Anwendung im Bereich von tiefen Weichteilverletzungen bei Menschen oder Tieren. Denkbar ist, dass durch das beschriebene Verfahren auch tiefe und/ oder größere Wunden geklebt werden können. Denkbar ist ein minimalinvasives Kleben von tiefen und/oder großen Wunden. Denkbar ist generell ein Kleben von menschlichen, tierischen oder pflanzlichen, Geweben und/oder Organen jeder Art.

Insbesondere ist denkbar, dass die Kapseln eines Einkomponenten-Kapselsystems oder Mehrkomponenten-Kapselsystems, z.B. eines Zweikomponenten-Kapselsystems zusätzlich oder alternativ pharmakologisch wirksame Substanzen enthalten, beispielsweise Arzneimittel inklusive Antibiotika, Wachstumsfaktoren, Desinfektionsmittel, oder ähnliches. Dies kann beispielsweise eine bessere Wundheilung oder Verwachsung von Gewebe oder Organen aller Art ermöglichen.

Denkbar ist auch, dass die Kapseln eines Einkomponenten-Kapselsystems oder Mehrkomponenten-Kapselsystems, z.B. eines Zweikomponenten-Kapselsystems poröse Kapseln sind. Poröse Kapseln können eingesetzt werden, um Flüssigkeiten und/oder Gerüche aufzunehmen. Denkbar ist beispielsweise, dass poröse Kapseln zur Aufnahme von Wundflüssigkeit bei Wunden von Tieren, Menschen, oder auch Pflanzen eingesetzt werden.

Es ist auch möglich, dass über die Kapseln eines Mehrkomponenten-Kapselsystems, z.B. eines Zweikomponenten-Kapselsystems ein gewähltes Freisetzungsprofil erreicht wird. Denkbar ist beispielsweise eine stufenweise und/oder verzögerte Freigabe von Arzneimittel oder Wachstumsfaktoren und/oder Wirkstoffen aller Art.

Es ist denkbar, dass bei einem Zweikomponenten-Kapselsystem zu einer schnelleren Heilung einer Wunde eine erste Kapselpopulation mit Fibrin sofort aktiviert wird, eine zweite Kapselpopulation mit Antibiotika jedoch über einen verlängerten Aktivierungsmechanismus verfügt, so dass die Antibiotikafreisetzung verglichen mit der Fibrinfreisetzung verzögert erfolgt. Zusätzlich wäre es möglich, eine leere, poröse Kapsel einzubringen, die Gerüche und/oder Wundflüssigkeit aufsaugt.

Es ist denkbar, dass in einem Zweikomponenten-Mikrokapselsystem eine erste Kapselpopulation mit einer wässrigen Komponente (erste Phase) und eine zweite Kapselpopulation mit einer ölhaltigen Komponente (zweite Phase) enthält. Denkbar ist, dass ein Zweikomponenten-Mikrokapselsystem somit ermöglicht, die wässrige Komponente und die ölhaltige Komponente, also die erste Phase und die zweite Phase, in einem definierten Verhältnis in Lösung zu bringen. Denkbar ist, dass so ein Zweiphasenprodukt basierend auf einem Zweikomponenten-Mikrokapselsystem mit einem definierten Verhältnis (von erster Phase zu zweiter Phase) entstehen kann. Denkbar ist beispielsweise, dass ein Zweiphasenprodukt basierend auf einem Zweikomponenten-Mikrokapselsystem in einem definierten Verhältnis auf ein Gewebe/ eine Faser aufgetragen werden kann. Denkbar ist, dass durch ein Zweiphasenprodukt basierend auf einem Zweikomponenten-Mikrokapselsystem Substanzen nicht austrocknen, und es ermöglichen in einer gängigen Verpackung gelagert werden zu können. Im Allgemeinen kann ein derartiges System dafür verwendet werden, dass Reaktionen effektiver als bei herkömmlichen Systemen ablaufen.

Denkbar ist auch, dass zwei Kapselpopulationen eines Zweikomponenten-Kapselsystems auf einem Trägermaterial im Batchverfahren mit demselben Inhalt, jedoch mit unterschiedlichen Aktivierungsmechanismen durch Intravernetzung aneinandergebunden werden. Dies kann eine länger andauernde Freisetzung von z.B. pharmakologisch wirksamen Substanzen verglichen mit einem Ein-Komponentenkapselsystem ermöglichen.

Denkbar ist ferner, dass bei einem Zweikomponenten-Kapselsystem instabile Substanzen durch Verkapselung länger in ihrer stabileren Form im

Umgebungsmedium gelagert werden. Erst bei Aktivierung der Kapseln kann die stabile Komponente in der ersten Kapsel mit dem Aktivator aus der zweiten Kapsel reagieren und in die reaktive Form überführt werden.

Eine weitere Anwendungsmöglichkeit eines doppel-oder einseitigen Trägermaterials beinhaltend die Kapseln, ist ein Klebeband und/oder Klebestreifen in Bereich der Körperpflege, in der Herstellung oder Reparatur von Bekleidung und/oder Schuhen, im Bau- oder Bastelbereich, im Heimwerken, Schreinern, in der Automobilindustrie, Klebetechnik, Elektroindustrie oder ähnliches.

Denkbar ist auch, dass die Kapseln des Einkomponenten-Kapselsystems und/oder des Zweikomponenten-Kapselsystems im Bereich von Pflegeprodukten für Menschen, Tiere, Pflanzen oder Gegenstände angewandt werden.

Denkbar ist, dass ein Mehrkomponentensystem, beispielsweise ein Zweikomponentensystem auch für selbstheilende Produkte verwendet werden kann.

Es ist möglich, dass sich ein Monomer in einer ersten Kapsel und ein Aktivator in einer anderen Kapsel verkapselt sind. Durch gezielte Aktivierung kann ein Kapselkomplex mit dem Umgebungsmedium reagieren.

Denkbar ist beispielsweise, dass Kapseln ein Zweikomponentensystems in Papier eingebracht werden. In der ersten Kapselpopulation können Zuckermonomere, in der zweiten Kapselpopulation ein entsprechendes aktivierendes Enzym verkapselt sein. Durch Aktivierung können die Kapseln platzen, und das aktivierende Enzym kann die Zuckermonomere an die Fasern des Papiers binden. Denkbar ist, dass so eine oder mehr Bruchstellen repariert werden können. Denkbar ist, dass dieses Prinzip auf Fasern jeder Art, beispielsweise Kunststofffasern angewandt wird.

Generell können Monomere in einer ersten Kapselpopulation vorliegen, und ein Initiator für die Polymerisation der Monomere in der ersten Kapselpopulation in einer anderen Kapselpopulation.

Dieses Prinzip kann bei Monomeren alle Art angewandt werden.

Generell können sich auch zwei Monomere in unterschiedlichen Kapseln befinden.

Beispielsweise kann die Carbonsäure in einer ersten Kapsel vorliegen und das Diol in einer zweiten Kapsel. Durch Aktivierung der Kapseln kann die Polykondensation aktiviert werden und die beiden Monomere reagieren zu einem Polyester.

Generell ist auch ein Dreikapselsystem denkbar. In der ersten und zweiten Kapsel können sich jeweils ein gleiches oder ein unterschiedliches Monomer befinden. In der dritten Kapsel kann sich ein Initiator befinden.

Möglich wäre beispielsweise die Polykondensation von Phenoplast, wobei das Phenol in einer Kapsel vorliegt und das Aldehyd in einer anderen Kapsel. In der dritten Kapsel liegt der Initiator vor.

Generell kann dieses Prinzip auf jede Polymerisation angewandt werden.

Es ist möglich, dass die Kapseln zumindest teilweise einen oder mehrere Duftstoffe, Farbstoffe, Füllstoffe, Pflegeprodukte, Wachstumsfaktoren, Hormone, Vitamine, Spurenelemente, Fette, Säuren, Basen, Bleichmittel, Alkohole, Proteine, Enzyme, Nukleinsäuren, Hydrogele oder ähnliches enthalten.

Denkbar ist auch, dass die Kapseln des Einkomponenten-Kapselsystems oder des Zweikomponenten-Kapselsystems im Bereich von Reinigungsmitteln angewandt werden. Demnach ist es möglich, dass die Kapseln zumindest teilweise einen oder mehrere Duftstoffe, Farbstoffe, Detergenzien, Tenside, Alkohole, Säuren, Basen, Bleichmittel, Enzyme oder ähnliches enthalten.

Denkbar ist auch, dass die Kapseln des Einkomponenten-Kapselsystems oder des Zweikomponenten-Kapselsystems im Bereich von Diagnoseverfahren angewandt werden. Demnach ist es möglich, dass die Kapseln zumindest teilweise Kontrastmittel, fluoreszierende Stoffe und/oder Farbstoffe enthalten.

Insbesondere ist denkbar, dass homogen und/oder heterofunktionalisierte Kapselpopulationen eines Zweikomponenten-Kapselsystems kovalent aneinandergebunden werden. Insbesondere ist denkbar, dass homogen und/oder heterofunktionalisierte Kapselpopulationen eines Zweikomponenten-Kapselsystems durch Intravernetzung und/oder Intervernetzung kovalent aneinandergebunden werden. Beide Kapselpopulationen können mit jeweils unterschiedlichen Stoffen, z.B. unterschiedlichen Farbstoffen gefüllt sein. Es ist denkbar, dass sich die eine Kapselpopulation bei einem bestimmten Ereignis durch einen bestimmten Aktivierungsmechanismus entleert, und sich die andere Kapselpopulation bei einem zweiten bestimmten Ereignis durch einen bestimmten Aktivierungsmechanismus entleert. Wenn beide Ereignisse eintreten mischen sich die beiden Kapselinhalte, sodass eine bestimmte Farbe entsteht.

Denkbar ist auch, dass ein Trägermaterial mit mindestens einer funktionellen Gruppe ausgebildet wird, um eine Anbindung an eine Oberfläche funktionalisierter Kapseln zu ermöglichen.

Insbesondere ist es denkbar, dass mindestens ein Bereich einer Oberfläche, welcher zu verkleben ist, mit funktionellen Gruppen ausgebildet wird. Zudem können Kapseln eines Einkomponenten-Kapselsystems und Mehrkomponenten-Kapselsystems wie oben beschreiben mit funktionellen Gruppen ausgebildet werden. Anschließend werden die Kapseln auf die funktionalisierte Oberfläche durch Vernetzung kovalent gebunden. Durch Aktivierung der Kapseln wird Klebstoff entleert und/oder untereinander vermischt, wodurch sich die Klebeeigenschaften entwickeln.

Zudem kann die Oberfläche des Trägermaterials eines Klebebandes funktionalisiert sein. Die ein- und Mehrkomponentensysteme werden in den Haftklebstoff eingemischt. Im nächsten Schritt wird ein Teil der Kapselkomplexe an der Oberfläche des Trägermaterials gebunden.

In einem weiteren Ausführungsbeispiel können die Kapselkomplexe auf die gesamte oder Teile der Oberfläche des Haftklebstoffes aufgebracht werden.

Es ist generell möglich, die Kapseln durch Lösungsmittelverdampfung, Thermogelierung, Gelbildung, Grenzflächenpolykondensation, Polymerisation, Sprühtrocknung, Wirbelschicht, Tröpfchenfrosten, Extrusion, überkritisches Fluid, Koazervation, Luftfederung, Pfannenbeschichtung, Co-Extrusion, Lösungsmittelextraktion, molekulare Einbindung, Sprühkristallisation, Phasentrennung, Emulsion, in situ Polymerisation, Unlöslichkeit, Grenzflächenabscheidung, Emulgierung mit einem Nanomolsieb, ionotrope Gelationsmethode, Koazervationsphasentrennung, Matrix-Polymerisation, interfaziale Vernetzung, congealing Methode, Zentrifugationsextrusion und/oder ein oder mehrere weitere Verfahren herzustellen.

Es ist generell möglich, Kapseln durch physikalische Methoden, chemische Methoden, physiochemische Methoden und/oder ähnliche Methoden herzustellen.

Es ist generell möglich, dass die Hülle der Kapseln mindestens ein Polymer, Wachs Harz, Protein, Polysaccharid, Gummi arabicum, Maltodextrin, Inulin, Metall, Keramik, Acrylat, Mikrogel, Phasenaustauschmaterial und/oder einen oder mehrere weitere Stoffe umfasst.

Es ist generell möglich, dass die Hülle der Kapseln nicht porös oder nicht ganz porös ist. Es ist generell möglich, dass die Hülle der Kapseln beinahe ganz undurchlässig oder ganz undurchlässig ist.

Es ist generell möglich, dass der Kern der Kapseln fest, flüssig und/oder gasförmig ist. Zudem ist es möglich, dass der Kern der Kapseln mindestens ein Phasenwechselmaterial, Enzym, Carotinoid, lebende Zellen, mindestens eine phenolische Verbindung oder ähnliches umfasst.

Es ist generell möglich, dass die Kapseln mit linearen Polymeren, Polymeren mit Multivalenz, sternförmigen Polyethylenglycolen, self-assembled monolayer (SAM), Kohlenstoff-Nanoröhrchen, ringförmigen Polymere, Dendrimeren, Leiterpolymeren und oder ähnlichen Stoffen ausgebildet sind.

Mögliche Schutzgruppen umfassen Acetyl, Benzoyl, Benzyl, β-Methoxyethoxymethylether, Methoxytriyl, 4-Methoxyphenyl)diphenylmethyl, Dimethoxytrityl, Bis-(4-Methoxyphenyl)phenylmethyl, Methoxymethylether, p-Methoxybenzylether, Methylthiomethylether, Pivaloyl, Tetrahydrofuryl, Tetrahydropyranyl, Trityl, Triphenylmethyl, Silylether, tert-Butyldimethylsilyl, Tri-isopropylsilyloxymethyl, Triisopropylsilyl, Methylether, Ethoxyethylether.p-Methoxybenzylcarbonyl, tert-Butyloxycarbonyl, 9-Fluorenylmethyloxycarbonyl, Carbamate, p- Methoxybenzyl, 3,4-Dimethoxybenzyl, p-Methoxyphenyl, eine oder mehrere Tosyl- oder Nosylgruppen, Methylester, Benzylester, tert-Butylester, 2, 6-disubstituierte Phenolester (z.B. 2,6-Dimethylphenol, 2,6-Diisopropylphenol, 2,6-Di-tert-butylphenol), Silylester, Orthoester, Oxazolin, und oder Ähnliche.

Mögliche Materialien für das Coating der Kapseln umfassen Albumin, Gelatine, Kollagen, Agarose, Chitosan, Stärke, Carragen, Polystärke, Polydextran, Laktiden, Glykolide und Co-Polymere, Polyalkylcyanoacrylat, Polyanhydrid, Polyethylmethacrylat, Acrolein, Glycidylmethacrylat, Epoxid-Polymere, Gummi Arabicum, Polyviylalkohol, Methylcellulose, Carboxymethylcellulose, Hydroxyethylcellulose, Arabinogalaktan, Polyacrylsäure, Ethylcellulose, Polyethylen Polymethacrylat, Polyamid (Nylon), Polyethylenvinylacetat, Cellulosenitrat, Silikone, Poly(lactide-co-glycolide), Paraffin, Carnauba, Spermaceti, Bienenwachs, Stearinsäure, Stearylalkohole, Glycerinstearat, Schellack, Celluloseacetatphthalat, Zein, Hydrogele oder Ähnliche.

Mögliche funktionelle Gruppen umfassen Alkane, Cycloalkane, Alkene, Alkine, Phenyl-Substituenten, Benzyl-Substituenten, Vinyl, Allyl, Carbene, Alkylhalogenide, Phenol, Ether, Epoxide, Ether, Peroxide, Ozonide, Aldehyde, Hydrate, Imine, Oxime, Hydrazone, Semicarbazone, Halbacetale, Halbketale, Lactole, Acetal/ Ketal, Aminale, Carbönsäure, Carbonsäureester, Lactone, Orthoester, Anhydride, Imide, Carbonsäurehalogenide, Carbonsäurederivate, Amide, Lactame, Peroxisäuren, Nitrile, Carbamate, Hernstoff, Guanidine, Carbodiimide, Amine, Anilin, Hydroxylamine, Hydrazine, Hydrazone, Azoverbindungen, Nitroverbindungen, Thiole, Mercaptane, Sulfide, Phosphine, P-Ylene, P-Ylide, Biotin, Streptavidin, Metallocene, oder Ähnliche.

Mögliche Freisetzungsmechanismen umfassen Diffusion, Auflösung, Degradationskontrolle, Erosion, oder ähnliche.

Denkbar ist, dass ein kombinierter Freisetzungsmechanismus vorliegt.

Mögliche Linker umfassen Biopolymere, Proteine, Seide, Polysaccaride, Zellulose, Stärke, Chitin, Nukleinsäure, synthetische Polymere, Homopolymere, Polyethylene, Polypropylene, Polyvinylchlorid, Polylactam, Naturkautschuk, Polyisopren, Copolymere, statistische Copolymere, Gradientcopolymer, alternierendes Copolymer, Blockcopolymer, Pfropfcopolymere, ArcylnitrilButadien-Styrol (ABS), Styrol-Acrylnitril (SAN), Buthylkautschuk, Polymerblends, Polymerlegierung, anorganische Polymere, Polysiloxane, Polyphophazene, Polysilazane, Keramik, Basalt, isotaktische Polymere, syndiodaktische Polymere, ataktisch Polymere, lineare Polymere, vernetzte Polymere, Elastomere, thermoplastische Elastomere, Duroplasten, teilkristalline Linker, Thermoplaste, cis-trans Polymere, leitfähige Polymere, supramolekulare Polymere.

Ein Linker kann jede Form von Verbindung zwischen einer Kapsel und einer funktionellen Gruppe sein.

Des Weiteren betrifft die vorliegende Erfindung ein Verfahren zur Herstellung eines Mehrkomponentensystems. Danach ist vorgesehen, dass bei einem Verfahren zur Herstellung eines Mehrkomponentensystems mit wenigstens einem ersten Stoff und mit wenigstens einem zweiten Stoff, wobei der erste Stoff und der zweite Stoff in mehreren Stoffportionen vorliegt, wobei das Mehrkomponentensystem aktivierbar ist, das Verfahren die folgenden Schritte umfasst:
- die ersten Stoffportionen werden mit wenigstens einer ersten funktionellen Gruppe ausgebildet und mit einem ersten Linker versehen,
- die zweiten Stoffportionen werden mit wenigstens einer zweiten funktionellen Gruppe ausgebildet und mit einem zweiten Linker versehen,
- die erste funktionelle Gruppe reagiert über eine vordefinierte Wechselwirkung mit der zweiten funktionellen Gruppe, so dass diese miteinander verbunden werden, und
- der Abstand der funktionellen Gruppen zu der jeweiligen Stoffportion wird durch den jeweiligen Linker bestimmt.

Es kann insbesondere vorgesehen sein, dass die ersten Stoffportionen mit wenigstens einer dritten funktionellen Gruppe ausgebildet und mit einem dritten Linker versehen sind, wobei die dritte funktionelle Gruppe jeweils wenigstens eine Schutzgruppe aufweist, so dass an die Stoffportionen des ersten Stoffes nur entsprechend funktionalisierte Stoffportionen des ersten Stoffes binden können, und wobei das Verfahren weiter wenigstens den Schritt umfasst, dass die Schutzgruppen zunächst vorliegen und erst dann entfernt werden, wenn die ersten Stoffportionen mittels der dritten funktionellen Gruppen miteinander verbunden werden sollen. Dadurch wird verhindert, dass sich die Stoffportionen, insbesondere Kapseln, des ersten Stoffes bereits und vorzugsweise mit weiteren Stoffportionen des ersten Stoffes verbinden. Die Schutzgruppen können nach einbringen in Gas, niedrig viskose, flüssige, hochviskose oder feste Phase entfernt werden, wodurch die Intravernetzung stattfindet.

Bei dem Mehrkomponentensystem kann es sich um ein Mehrkomponentensystem wie vorstehend beschrieben handeln.

Mögliche Anwendungsgebiete des erfindungsgemäßen Verfahrens oder Systems umfassen die Biotechnologie, Kosmetik, Pharmaindustrie, Lebensmittelindustrie, chemische Industrie, Landwirtschaft, Verpackungstechnik, Abfallverwertung, Textilindustrie, Herstellung von Faserverbundwerkstoffen, Elektrotechnik, Maschinenbau, Medizintechnik, Mikrotechnik, Automobilindustrie, Farben, Lacke oder ähnliches.

Explizit offenbart wird somit die Verwendung des vorstehend und auch nachstehend beschriebenen Verfahrens und/oder Systems für eine der folgenden Anwendungen, allein oder in Kombination, nämlich der Biotechnologie, der Pharmaindustrie, der Kosmetik, der Lebensmittelindustrie, der chemischen Industrie, der Landwirtschaft, der Verpackungstechnik, der Abfallverwertung, der Textilindustrie, der Herstellung von Faserverbundwerkstoffen, der Elektrotechnik (z.B. im Zusammenhang mit der Verbindung von elektronischen Bauelement, der Chiptechnologie oder dergleichen), des Maschinenbaus, der Medizintechnik, der Mikrotechnik, der Automobilindustrie oder dergleichen. Insbesondere wäre im Kosmetik Bereich folgendes zu nennen:

In der Kosmetik gibt es viele Zwei-Phasen bzw. Mehrphasen Produkte. Häufig liegt hier eine wässrige und eine ölhaltige Komponente vor. Durch die 2K-Mikrokapseltechnologie ist es möglich beide Phasen in einem definierten Verhältnis in Lösung zu bringen.

In einem weiteren Ausführungsbeispiel können die zwei Phasen Produkte mit den 2K-Kapseln in einem definierten Verhältnis auf ein Wattepad aufgetragen werden. Dies hätte zum einen den Vorteil, dass die Substanzen nicht austrocknen, somit in einer normalen Verpackung gelagert werden können, zudem ist wird die Effizienz, mit der die Substanzen ihre Wirkung entfalten mit demselben Materialeinsatz deutlich gesteigert. Die Effizienzsteigerung von zwei Substanzen kann zudem auch in Cremes, Masken uns. angewandt werden.

Generell kann das Prinzip der Zweiphasensysteme wie oben beschrieben auf alle Mehrphasensysteme angewandt werden.

Zudem kann ganz generell das Prinzip dafür verwendet werden, dass bei Reaktionen die Ausbeute erhöht wird und/oder Reaktionen effektiver ablaufen.

Im Bereich Produktentwicklung wäre z.B. selbstheilende Produkte denkbar:
Das 2K-System kann auch für selbstheilende Produkte verwendet werden. In einer Variante befindet sich das Monomer in der einen Kapsel und der Aktivator bzw. das zweite Monomer in der anderen Kapsel. Durch gezielte Aktivierung reagiert der Kapselkomplex mit dem Umgebungsmedium und verbindet die Bruchstücke miteinander.

Zum Beispiel könnten die Kapseln in Papier eingebracht werden. In der einen Kapsel wären Zucker Monomere in der anderen Kapsel wäre das entsprechende Enzym. Durch eine Aktivierung, z.B. durch UV-Strahlung würden die Kapseln platzen, das Enzym würde die entsprechenden Zuckermonomere an die Fasern Binden und die Bruchstelle wäre dann wieder repariert.

Dasselbe Prinzip könnte auch bei Fasern, insbesondere Kunststofffasern angewandt werden. Die Monomere würden in der einen Kapsel vorliegen, der Initiator für die Polymerisation in der anderen Phase.

Dieses Prinzip kann auch bei Farben, Lacke und vielen anderen Materialen angewandt werden. Weitere Einzelheiten und Vorteile der Erfindung sollen nun anhand eines in den Zeichnungen näher gezeigten Ausführungsbeispiels erläutert werden.

Es zeigen:
- Fig. 1: ein Ausführungsbeispiel eines erfindungsgemäßen Mehrkomponentensystems mit einem ersten Stoff und mit einem zweiten Stoff;
- Fig. 2: ein weiteres Ausführungsbeispiel eines erfindungsgemäßen Mehrkomponentensystems mit einem ersten Stoff und mit einem zweiten Stoff;
- Fig. 3: ein weiteres Ausführungsbeispiel eines erfindungsgemäßen Mehrkomponentensystems nach Fig. 1 oder Fig. 2;
- Fig. 4: ein weiteres Ausführungsbeispiel eines erfindungsgemäßen Mehrkomponentensystems nach Fig. 1, Fig. 2 oder Fig. 3;
- Fig. 5: ein Ausführungsbeispiel einer erfindungsgemäßen Intervernetzung zweier unterschiedlicher Stoffportionen/ Kapselpopulation;
- Fig. 6: ein Ausführungsbeispiel einer erfindungsgemäßen Intravernetzung zweier gleicher Stoffportionen/ Kapselpopulation;
- Fig. 7: ein Ausführungsbeispiel eines erfindungsgemäßen Zweikomponentensystems;
- Fig. 8: ein Ausführungsbeispiel eines erfindungsgemäßen intravernetzten Kapselsystems;
- Fig. 9: ein Ausführungsbeispiel eines erfindungsgemäßen inter-und intravernetzten Zweikomponentensystems gemäß Fig. 7;
- Fig. 10: ein Flussdiagramm des Workflows der Herstellung eines Zweikomponentenklebebandes gemäß der vorliegenden Erfindung;
- Fig. 11A: ein Ausführungsbeispiel von intravernetzten Kapseln eines Einkomponentensystems gemäß der vorliegenden Erfindung;
- Fig. 11B: ein Ausführungsbeispiel von intravernetzten Kapseln eines Einkomponentensystems und unvernetzten mit Gas befüllten Kapseln gemäß der vorliegenden Erfindung;
- Fig. 12A: ein Ausführungsbeispiel von inter- und intravernetzten Kapseln eines Zweikomponentensystems gemäß der vorliegenden Erfindung;
- Fig. 12B: eine schematische Darstellung von inter- und intravernetzten Kapseln eines Mehrkomponentensystems und unvernetzten mit Gas befüllten Kapseln gemäß der vorliegenden Erfindung;
- Fig. 13: eine Darstellung der Bindungsverhältnisse von Mikrokapseln in einem erfindungsgemäßen Zweikomponentensystem gemäß der vorliegenden Erfindung; und
- Fig. 14: eine Darstellung der erfindungsgemäßen Bindung von Mikrokapseln mit der gleichen Größe aber mit einer unterschiedlichen Funktionalisierung.

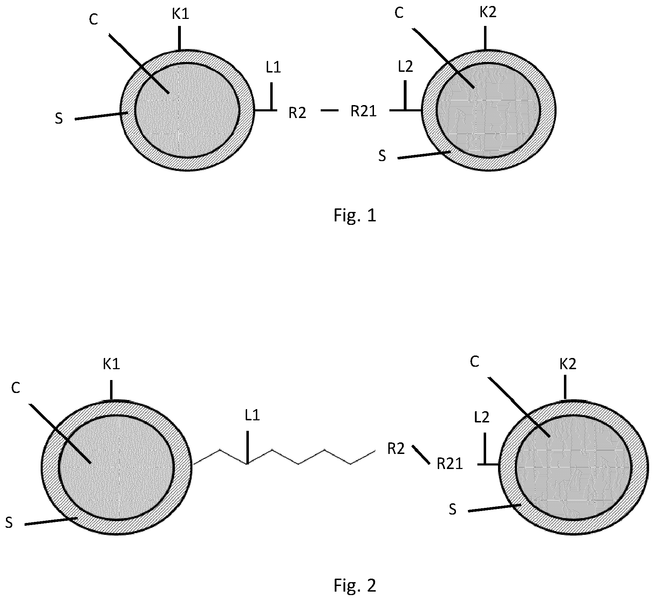

**Fig. 1** zeigt ein Ausführungsbeispiel eines erfindungsgemäßen Mehrkomponentensystems mit einem ersten Stoff und mit einem zweiten Stoff.

In diesem Ausführungsbeispiel ist das Mehrkomponentensystem aktivierbar.

Es ist möglich, dass der erste Stoff und der zweite Stoff in mehreren Stoffportionen vorliegen.

In diesem Ausführungsbeispiel liegt der erste Stoff in einer Kapselpopulation K1 vor.

In anderen Worten, in diesem Ausführungsbeispiel sind die ersten Stoffportionen erste Kapseln K1.

In diesem Ausführungsbeispiel liegt der zweite Stoff in einer Kapselpopulation K2 vor.

In anderen Worten, in diesem Ausführungsbeispiel sind die zweiten Stoffportionen zweite Kapseln K2.

Generell ist es möglich, dass eine Stoffportion des ersten Stoffes und/oder des zweiten Stoffes in einer Kapsel K, insbesondere einer Nanokapsel und/oder Mikrokapsel angeordnet ist.

Die Stoffportion bildet dabei in K1 und K2 jeweils einen Kern C (auch core genannt), der von einer Kapselhülle S (auch shell genannt) umgeben ist. Es handelt sich somit um ein "Core-Shell" Konstrukt. Grundsätzlich denkbar sind aber auch Core-Shell-Shell Konstrukte.

In diesem Ausführungsbeispiel sind die ersten Stoffportionen mit wenigstens einer ersten funktionellen Gruppe R2 ausgebildet und mit einem ersten Linker L1 versehen.

In diesem Ausführungsbeispiel sind die zweiten Stoffportionen mit wenigstens einer zweiten funktionellen Gruppe R21 ausgebildet und einem zweiten Linker L2 versehen.

In diesem Ausführungsbeispiel reagiert die erste funktionelle Gruppe R2 über eine vordefinierte Wechselwirkung mit der zweiten funktionellen Gruppe R21 und verbindet diese miteinander.

In diesem Ausführungsbeispiel ist der Abstand der funktionellen Gruppen zu der jeweiligen Stoffportion durch den jeweiligen Linker L bestimmt.

Die in den **Fig. 2-6** gezeigten Kapseln sind identisch aufgebaut wie die in Fig. 1 gezeigten Kapseln K1 und K2.

In diesem Ausführungsbeispiel sind die ersten Stoffportionen mit wenigstens einer ersten funktionellen Gruppe R2 ausgebildet und mit einem ersten Linker L1 versehen.

In diesem Ausführungsbeispiel sind die zweiten Stoffportionen mit wenigstens einer zweiten funktionellen Gruppe R21 ausgebildet und einem zweiten Linker L2 versehen.

In diesem Ausführungsbeispiel reagiert die erste funktionelle Gruppe R2 über eine vordefinierte Wechselwirkung mit der zweiten funktionellen Gruppe R21 und verbindet diese miteinander.

In diesem Ausführungsbeispiel ist der Abstand der funktionellen Gruppen zu der jeweiligen Stoffportion durch den jeweiligen Linker L bestimmt.

Es ist möglich, dass der erste Linker L1 länger als der zweite Linker L2 ist, vgl. **Fig. 2****.**

Alternativ ist es möglich, dass er zweite Linker L2 länger ist als der erste Linker L1.

Alternativ ist es möglich, dass beide Linker L1 und L2 gleich lang sind.

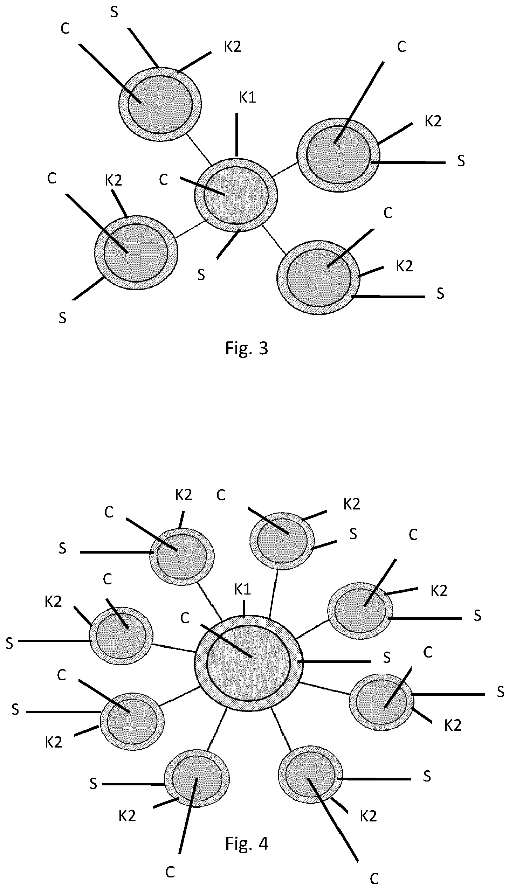

**Fig. 3** zeigt ein Ausführungsbeispiel eines erfindungsgemäßen Mehrkomponentensystems nach Fig. 1 oder Fig. 2.

In diesem Ausführungsbeispiel unterscheiden sich die ersten Stoffportionen und die zweiten Stoffportionen.

In anderen Worten, in diesem Ausführungsbeispiel unterscheidet sich die Kapseln K1 der erste Kapselpopulation von den Kapseln K2 der zweiten Kapselpopulation.

In diesem Ausführungsbeispiel sind die ersten Stoffportionen mit einer größeren Anzahl an Stoffportionen verbunden bzw. verbindbar als die zweiten Stoffportionen.

In anderen Worten, in diesem Ausführungsbeispiel sind die Kapseln K1 mit einer größeren Anzahl an Kapseln K verbunden bzw. verbindbar als die Kapseln K2.

Alternativ ist es möglich, dass die zweiten Stoffportionen mit einer größeren Anzahl an Stoffportionen verbunden bzw. verbindbar als die ersten Stoffportionen.

In anderen Worten, es ist möglich, dass die Kapseln K2 mit einer größeren Anzahl an Kapseln K verbunden bzw. verbindbar sind als die Kapseln K1.

**Fig. 4** ein weiteres Ausführungsbeispiel eines erfindungsgemäßen Mehrkomponentensystems nach Fig. 1, Fig. 2, oder Fig. 3.

In diesem Ausführungsbeispiel weisen die ersten Stoffportionen und die zweiten Stoffportionen eine im Wesentlichen unterschiedliche Größe auf.

In diesem Ausführungsbeispiel weisen die ersten Kapseln K1 eine im Wesentlichen größere Größe auf als die zweiten Kapseln K2.

Generell kann eine Kapsel K1 für einen ersten Stoff eine andere Größe aufweisen als eine Kapsel K2 für einen zweiten Stoff, insbesondere wobei die Kapsel K1 für den ersten Stoff größer ist als die Kapsel K2 für den zweiten Stoff.

Alternativ ist es möglich, dass die zweiten Stoffportionen eine im Wesentlichen größere Größe als die ersten Stoffportionen aufweisen.

Alternativ ist es möglich, dass die ersten Stoffportionen und die zweiten Stoffportionen eine im Wesentlichen identische Größe aufweisen.

Nicht gezeigt ist, dass die ersten Stoffportionen eine im Wesentlichen identische Größe aufweisen und/oder dass die zweiten Stoffportionen eine im Wesentlichen identische Größe aufweisen können.

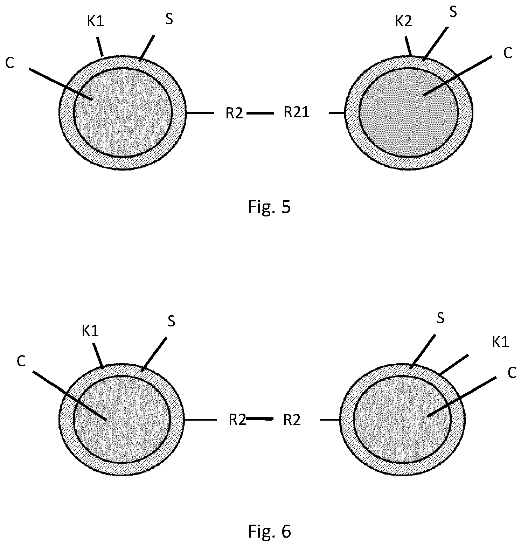

**Fig. 5** zeigt ein Ausführungsbeispiel einer erfindungsgemäßen Intervernetzung zweier unterschiedlicher Stoffportionen.

In diesem Ausführungsbeispiel sind eine Kapsel K1 und eine Kapsel K2 intervernetzt.

In diesem Ausführungsbeispiel sind eine Kapsel K1 und eine Kapsel K2 via die funktionellen Gruppen R2 und R21 intervernetzt.

**Fig. 6** zeigt ein Ausführungsbeispiel einer erfindungsgemäßen Intravernetzung zweier gleicher Stoffportionen.

In diesem Ausführungsbeispiel sind zwei Kapseln K1 intravernetzt.

In diesem Ausführungsbeispiel sind die zwei Kapseln K1 über die funktionellen Gruppen R2 - R2 intravernetzt.

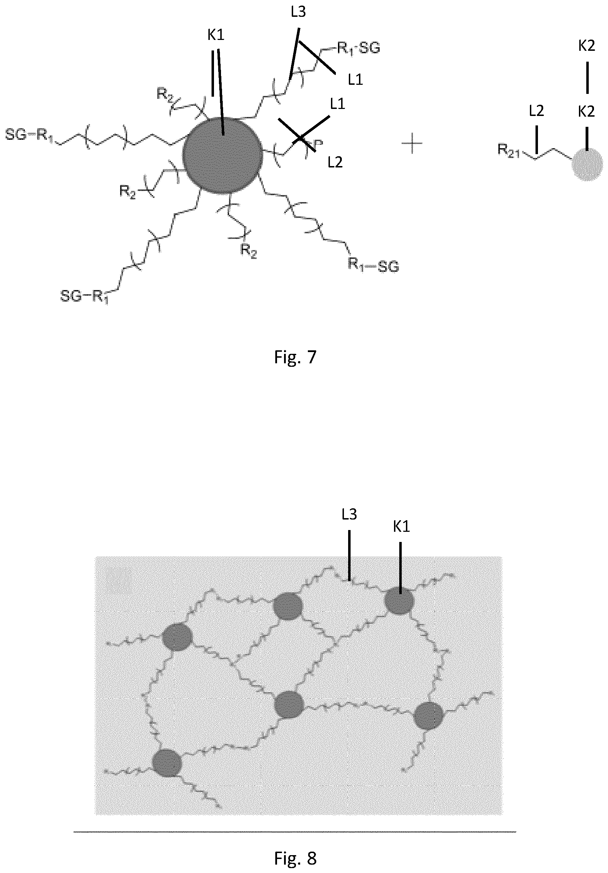

**Fig. 7** ein Ausführungsbeispiel eines erfindungsgemäßen Zweikomponentensystems.

In diesem Ausführungsbeispiel ist das Zweikomponentensystem ein Zweikom ponenten-M ikrokapselsystem .

In diesem Ausführungsbeispiel ist das Zweikomponentensystem ein Zweikomponenten-Mikrokapselsystem, das noch nicht über eine vordefinierte Wechselwirkung miteinander reagiert hat.

Insbesondere sind zwei unterschiedliche Kapselpopulationen K1 und K2 dargestellt, wobei ein erster Stoff in der ersten Kapsel K1 ist und ein zweiter Stoff in der zweiten Kapsel K2 ist.

Die dargestellten Kapseln K1 und K2 stehen exemplarisch für eine Vielzahl von Kapseln K1 und K2, z.B. zu bezeichnen als Kapselpopulationen.

In diesem Ausführungsbeispiel ist der erste Stoff in der einen Kapsel K1 eine erste Klebstoffkomponente.

In diesem Ausführungsbeispiel ist der zweite Stoff in der zweiten Kapsel K2 eine zweite Klebstoffkomponente.

In anderen Worten, der erste Stoff und der zweite Stoff sind Bestandteile eines Mehrkomponentenklebstoffes, insbesondere Zweikomponentenklebstoffes.

Es ist generell möglich, dass die zwei unterschiedlichen Kapselpopulationen K1 und K2 in separaten Batch Reaktoren hergestellt wurden.

Die Kapseln K1 und K2 der beiden Kapselpopulationen sind funktionalisiert.

Die ersten Kapseln K1 wurden mit zwei verschiedenen Linkern L1 und L3 unterschiedlicher Länge und mit unterschiedlichen funktionellen Gruppen R1 und R2 an der Oberfläche ausgebildet (Oberflächenfunktionalisierung).

Mit anderen Worten, die funktionellen Gruppen R sind heterogen ausgebildet.

In einem alternativen Ausführungsbeispiel ist es möglich, dass die funktionellen Gruppen R homogen ausgebildet sind.

Die zweiten Kapseln K2 wurden mit dem Linker L2 und mit der funktionellen Gruppe R21 ausgebildet.

Die funktionelle Gruppe R21 der zweiten Kapsel K2 reagiert kovalent mit der funktionellen Gruppe R₂ der ersten Kapsel K1.

In diesem Ausführungsbeispiel ist es möglich, dass die ersten Kapseln K1 mit einer größeren Anzahl an Kapseln K verbunden sind bzw. verbindbar sind als die zweiten Kapseln K2.

In einem alternativen Ausführungsbeispiel ist es möglich, dass die zweiten Kapseln K2 mit einer größeren Anzahl an Kapseln K verbunden sind bzw. verbindbar sind als die ersten Kapseln K1.

Der Linker L3 und die funktionelle Gruppe R1 soll die ersten Kapseln K1 untereinander vernetzen (Intravernetzung).

Über den Linker L1 und die funktionelle Gruppe R2 und den Linker L2 und die funktionelle Gruppe R21 werden die Kapseln K2 kovalent an die erste Kapsel K1 gebunden (Intervernetzung).

Durch Aktivierung beider Kapseln K1 und K2 kann der Inhalt der Kapseln K1 und K2 freigesetzt werden, was zu einer Vermischung beider Komponenten führt.

Es ist generell möglich, über die Dichte der Oberflächenfunktionalisierung bzw. Anzahl an funktionellen Gruppen R2 der ersten Kapsel K1 die Anzahl an zweiten Kapseln K2, die an die ersten Kapseln K1 binden, zu bestimmen.

Generell können in den Kapseln K1 und K2 zwei reaktive Stoffe voneinander getrennt eingekapselt und in einem bestimmten Verhältnis über u.a. kovalente (z.B. Click-Chemie), schwache Wechselwirkung, biochemisch (z.B. Biotin-Streptavidin) oder auf andere Art und Weise gebunden werden.

Es ist generell möglich, dass mehr als zwei unterschiedliche Kapseln Kn mehr als zwei unterschiedliche Stoffe, z.B. reaktive Stoffe einkapseln.

Es ist generell möglich, dass die unterschiedlichen Kapseln Kn mit mehr als zwei Linkern Ln und mit unterschiedlichen funktionellen Gruppen Rn ausgebildetsind.

Es ist generell möglich, dass ein Linker L jede Form von Verbindung zwischen einer Kapsel und einer funktionellen Gruppe ist.

Es ist generell möglich, dass bei heterogener Funktionalisierung eine funktionelle Gruppe R zum Binden an Oberflächen, Fasern oder Textilien verwendet werden kann.

Wie bei bestehenden Kapselsystemen kann jeder denkbare Stoff in die Kapseln K1 und/oder K2 und/oder Kn eingebracht werden.

Die Aktivierung des Zweikomponentensystems kann durch wenigstens eine Änderung von Druck, pH-Wert, UV-Strahlung, Osmose, Temperatur, Lichtintensität, Feuchtigkeit, oder dergleichen erfolgen.

Generell könnte ein Zweikomponenten-Kapselsystem in jedem beliebigen Medium umgesetzt werden.

**Fig. 8** zeigt ein Ausführungsbeispiel eines erfindungsgemäßen intravernetzten Kapselsystems.

In diesem Ausführungsbeispiel ist das intravernetze erfindungsgemäße Kapselsystem ein intravernetzes Mikrokapselsystem.

Gezeigt ist ein Einkomponentensystem.

Gezeigt ist eine Kapselpopulation K1.

Die Kapseln K1 sind mit einem Stoff gefüllt.

In diesem Ausführungsbeispiel sind die Kapseln K1 mit einem Klebstoff gefüllt.

In diesem Ausführungsbeispiel sind die Kapseln K1 mit einem EinKomponentenklebstoff gefüllt.

Alternativ können die Kapseln K1 mit jedem denkbaren gasförmigen, festen, viskösen und/oder flüssigen Stoff gefüllt sein.

Alternativ können die Kapseln K1 auch mit lebenden Organismen und/oder Viren gefüllt sein.

Die Kapseln K1 wurden funktionalisiert.

Die Kapseln K1 wurden mit Linkern L3 versehen.

Nicht gezeigt ist, dass die Kapseln K1 mit funktionellen Gruppen R1 (am Linker L3) ausgebildet sind.

Die Linker L3 vernetzen die Kapseln K1 untereinander (Intravernetzung).

Der Abstand der Kapseln K1 kann durch die Länge der Linker L3 bestimmt werden.

Abhängig von der Dichte der Oberflächenfunktionalisierung R1 kann der Grad der Intravernetzung der Kapseln K1 bestimmt werden.

Die Länge des Linkers L3 ist so zu wählen, dass der Radius des Inhaltes der entleerten Flüssigkeit der Kapseln K1 sich mit dem Inhalt der Nachbarkapseln K1 leicht überschneidet um eine Vernetzung zu gewährleisten.

Bei einem höher viskosen Umgebungsmedium (wie z.B. einem Klebeband) wären die Länge des Linkers L3 kleiner zu wählen als bei einem niedrig viskoseren Medium wie eine Paste oder Flüssigkeit.

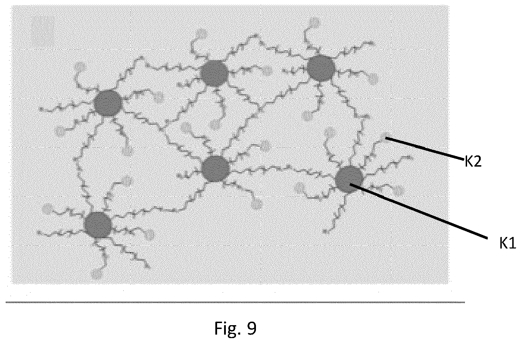

**Fig. 9** zeigt ein Ausführungsbeispiel eines erfindungsgemäßen inter-und intravernetzten Zweikomponentensystems gemäß Fig. 7.

Die ersten Kapseln K1 und die zweiten Kapseln K2 sind mit unterschiedlichen Stoffen gefüllt.

In diesem Ausführungsbeispiel weisen die Kapseln K1 eine im Wesentlichen identische Größe auf.

In diesem Ausführungsbeispiel weisen die Kapseln K2 eine im Wesentlichen identische Größe auf.

In diesem Ausführungsbeispiel weisen die Kapseln K1 und die Kapseln K2 eine unterschiedliche Größe auf.

In einem alternativen Ausführungsbeispiel ist es möglich, dass die Kapseln K1 und die Kapseln K2 eine im Wesentlichen identische Größe aufweisen.

Das Grundsystem entspricht der Darstellung in Fig. 8.

Zudem sind die ersten Kapseln K1 heterogen mit einem Linker L1 ausgebildet.

An den Linker L1 bindet eine zweite Kapselpopulation K2, vgl. Fig. 1.

In anderen Worten, das Zweikomponentensystem weist eine Netzwerkstruktur mit Zwischenräumen auf, wobei die Netzwerkstruktur von den ersten Kapseln K1 ausgebildet wird, und wobei in den Zwischenräumen zumindest abschnittsweise je wenigstens eine Kapsel K2 angeordnet ist.

Es ist generell möglich, dass die Zweikomponenten-Kapseln K1 und K2 mit unterschiedlichem Inhalt, in die Gasphase eingebracht werden. So könnten diese z.B. in Inhalationsgeräten oder anderen *Drug Delivery* Systemen angewandt werden. Die inaktivierten Kapseln gelangen zum Wirkort und werden dort aktiviert und der Inhalt wird freigesetzt. Auch könnten Oberflächen mit dieser Dispersion beschichtet werden.

Es ist generell möglich, dass die Zweikomponenten-Kapseln K1 und K2 mit unterschiedlichen Inhalten in ein pastöses Medium eingebracht werden. Zum Beispiel könnte ein Zweikomponenten-Klebstoff hierfür verwendet werden. Die Paste ist inaktiv und kann gut verarbeitet werden, bis die Kapseln aktiviert werden und miteinander reagieren. Das ideale Mischungsverhältnis der Klebstoffe ist wie oben beschrieben durch das Verhältnis der ersten und zweiten Kapseln K1 und K2 bestimmt.

Auch in flüssigen Systemen kann der Vorteil des idealen Zusammensetzens der Zweikomponenten-Kapselsysteme genutzt werden. Da sich beide Kapseln K1 und K2 des Zweikomponenten-Kapselsystems in direkter Nähe befinden ist es sehr wahrscheinlich, dass die Kapseln K1 und K2 schneller und definierter miteinander reagieren als einzeln in Dispersion.

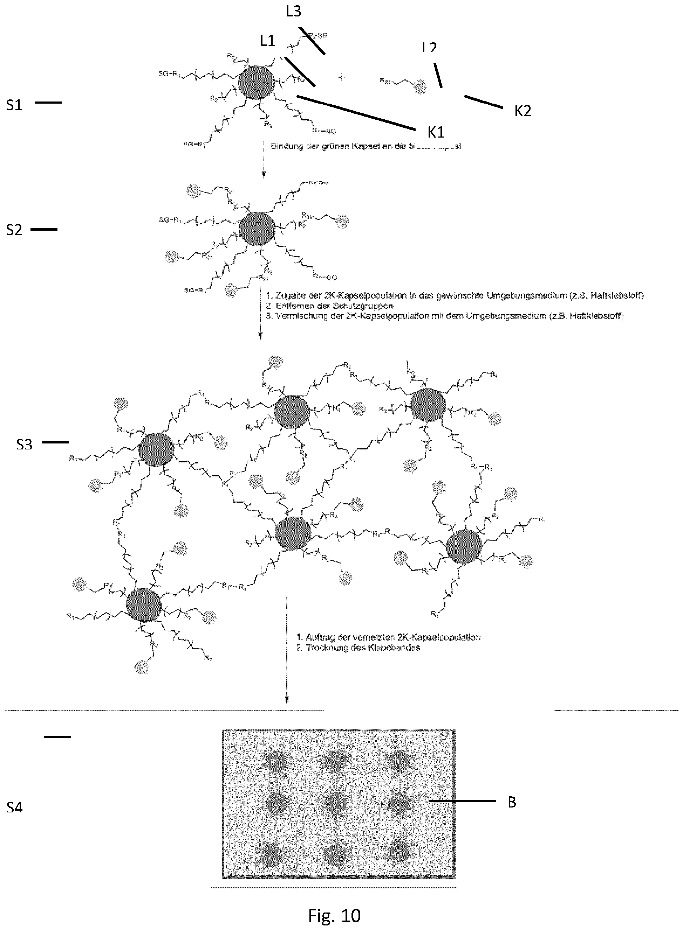

**Fig. 10** zeigt ein Flussdiagramm des Workflows der Herstellung eines erfindungsgemäßen Zweikomponenten-Klebebandes.

Fig. 10 basiert im Wesentlichen auf einem Zweikomponenten-Kapselsystem gemäß Fig. 7.

Insgesamt gliedert sich die Herstellung eines erfindungsgemäßen Zweikomponenten-Klebebandes in vier Schritte S1-S4.

In einem ersten Schritt S1 werden die ersten Kapseln K1 und die zweiten Kapseln K2 funktionalisiert, vgl. Fig. 7.

Bei dem vorliegenden Zweikomponentensystem werden die ersten Kapseln K1 mit zwei Linkern L1 und L3 heterogen mit den funktionellen Gruppen R1 und R2 ausgebildet.

In einem separaten Batch Ansatz wird die zweite Population der Kapseln K2 mit dem Linker L2 mit der funktionellen Gruppe R21 funktionalisiert.

Die funktionelle Gruppe R21 ist so zu wählen, dass diese im späteren Reaktionsschritt (kovalent) mit der funktionellen Gruppe R2 der ersten Kapsel K1 reagiert.

In einem zweiten Schritt S2 werden die funktionalisierten zweiten Kapseln K2 zu den funktionalisierten ersten Kapseln K1 gegeben.

Die funktionellen Gruppen R2 und R21 binden (kovalent) aneinander (Intervernetzung).

Es ist generell möglich, dass auch eine dritte oder beliebig viele weitere Kapselpopulationen K3-Kn zu einer ersten Kapselpopulation K1 und/oder einer zweiten Kapselpopulation K2 hinzugegeben werden.

Jede zusätzliche Kapselpopulation K3-Kn kann wiederum mit mindestens einer funktionellen Gruppe funktionalisiert sein.

In einem dritten Schritt S3 wird die heterogene Kapseldispersion aus dem vorangegangenen Schritt S2 in den noch niedrig viskosen Haftklebstoff, hier ein Klebeband B, eingebracht.

Es kommt zu einer vorgegebenen (Intra)-Vernetzungsreaktion, welche sich durch den gesamten Bereich des Klebebandes B ausbildet.

In einem vierten Schritt S4 werden die vernetzten Zweikomponenten-Kapselpopulationen aufgetragen und das Klebeband B wird getrocknet.

Hierbei erhöht sich die Viskosität des Klebebandes B deutlich, das Netzwerk bleibt jedoch homogen auf dem Klebeband verteilt.

Gezeigt ist, dass im Schritt S1, damit die ersten Kapseln K1 nicht schon vorzeitig untereinander während der Funktionalisierung miteinander vernetzen, noch eine Schutzgruppe SG an der funktionellen Gruppe R1 des Linkers L3 ausgebildet sein kann.

Weiter gezeigt ist, dass im Schritt S3 die Schutzgruppen SG entfernt werden.

Nicht gezeigt ist, dass durch die Entfernung der Schutzgruppe die Intravernetzung der Kapseln K1 ermöglicht wird.

Anwendungsmöglichkeiten in unterschiedlichen Umgebungsmedien:
Ausgehend von dem hier beschriebenen Workflow zur Herstellung eines erfindungsgemäßen Zweikomponenten-Klebebandes, kann das Zweikomponenten-Kapselsystem alternativ in anderen Medien und mit sämtlichen verkapselten Stoffen angewandt werden.

Als Umgebungsmedium sind unter anderem Gas, flüssige, pastöse, niedrig- und hochviskose Medien sowie feste Oberflächenbeschichtungen denkbar.

Es ist generell möglich, dass die Kapseln K als Nanokapseln oder Mikrokapseln ausgebildet sind.

Generell ermöglicht das Verfahren die Herstellung weiterer Mehrkomponentensysteme mit wenigstens einem ersten Stoff und mit wenigstens einem zweiten Stoff, wobei der erste Stoff und der zweite Stoff in mehreren Stoffportionen vorliegen, wobei das Mehrkomponentensystem aktivierbar ist, umfassend die folgenden Schritte:
- die ersten Stoffportionen werden mit wenigstens einer ersten funktionellen Gruppe R2 ausgebildet und mit einem ersten Linker versehen L1,
- die zweiten Stoffportionen werden mit wenigstens einer zweiten funktionellen Gruppe R21 ausgebildet und mit einem zweiten Linker L2 versehen,
- die erste funktionelle Gruppe R2 reagiert über eine vordefinierte Wechselwirkung mit der zweiten funktionellen Gruppe R21, so dass diese miteinander verbunden werden, und
- der Abstand der funktionellen Gruppen R zu der jeweiligen Stoffportion wird durch den jeweiligen Linker L bestimmt.

Es ist generell möglich, dass die ersten Stoffportionen mit wenigstens einer dritten funktionellen Gruppe R1 ausgebildet und mit einem dritten Linker L3 versehen sind.

Es ist generell möglich, dass die dritte funktionelle Gruppe R1 jeweils wenigstens eine Schutzgruppe SG aufweist, so dass an die Stoffportionen des ersten Stoffes nur entsprechend funktionalisierte Stoffportionen des ersten Stoffes binden können.

Es ist generell möglich, dass das Verfahren weiter wenigstens den Schritt umfasst, dass die Schutzgruppen SG zunächst vorliegen und erst dann entfernt werden, wenn die ersten Stoffportionen mittels der dritten funktionellen Gruppen R1 miteinander verbunden werden sollen.

Es ist generell möglich, dass die funktionellen Gruppen R1 jeweils wenigstens eine Schutzgruppe aufweisen, so dass an die Stoffportionen des ersten Stoffes nur entsprechend funktionalisierte Stoffportionen des zweiten Stoffes binden können.

Ferner ist es generell möglich, dass das Verfahren zur Herstellung eines Mehrkomponentensystems weiter wenigstens den Schritt umfasst, dass die Schutzgruppen zunächst vorliegen und erst dann entfernt werden, wenn die ersten und zweiten Stoffportionen mittels der ersten und zweiten funktionellen Gruppen R2, R21 miteinander verbunden werden sollen.

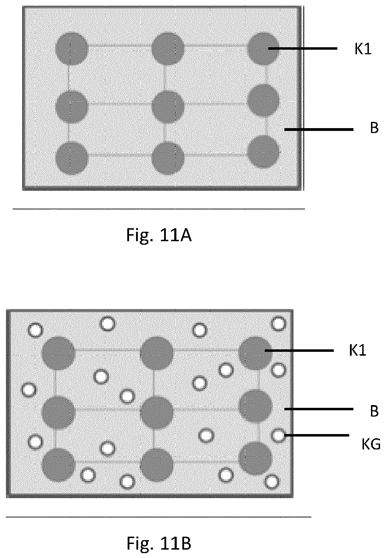

**Fig. 11A** zeigt eine schematische Darstellung von intravernetzten Kapseln eines Einkomponentensystems in einem hochviskosen System gemäß der vorliegenden Erfindung.

In diesem Ausführungsbeispiel ist das vernetzte Einkomponentensystem, wie in Fig. 8 beschrieben, in ein hochviskoses System eingebracht.

Das hochviskose System ist ein Klebeband B.

Alternativ sind andere hochviskose, flüssige, gasförmige, pastöse oder niedrigviskose Systeme denkbar.

In diesem Ausführungsbeispiel ist das Klebeband B ein einseitiges Klebeband B.

Alternativ sind auch doppelseitige Ausführungen eines Klebebands B möglich.

Üblicherweise besteht bei hochviskosen Systemen ein Diffusionsproblem, so dass der Inhalt der Kapseln K1 im Klebeband B keine Quervernetzung zwischen den beiden zu verklebenden Materialen erreicht.

Durch die (Intra)-Vernetzung des Einkomponentensystems kann der Abstand und der Vernetzungsgrad der Kapseln K1 so gewählt werden, dass der Inhalt der Kapseln K1 ein vernetzendes System durch den hochviskosen Klebstoff bildet.

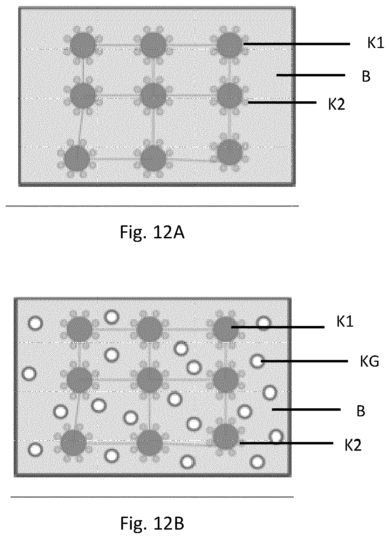

Dieses Grundprinzip kann auch auf ein Zweikomponentensystem wie in **Fig. 12A** dargestellt ausgeweitet werden. Dort wird der (Inter- und Intra-)-Vernetzungsmechanismus verwendet.

Nicht gezeigt ist, dass das Zweikomponentensystem auch nur mit einer vorherigen Intervernetzung der Kapseln K1 und der Kapseln K2 in das Klebeband eingebracht werden kann.

**Fig. 11B** zeigt eine schematische Darstellung von intravernetzten Kapseln eines Einkomponentensystems und unvernetzten, mit Gas befüllten Kapseln gemäß der vorliegenden Erfindung.

Alternativ können die unvernetzten Kapseln auch mit festen oder flüssigen Stoffen befüllt sein.

Zusätzlich zu den intravernetzten Kapseln K1 des Einkomponentensystems gemäß Fig. 11A kann eine weitere Population an unvernetzten, mit Gas gefüllten Kapseln KG in den hochviskosen Klebstoff, wie zum Beispiel ein Klebeband B, eingebracht werden, welche beim Aufplatzen das Gas freisetzen und somit entweder Freiraum für die flüssige Komponente der Kapseln K1 schaffen oder es ermöglichen das Klebeband wieder zu entfernen.

Es wäre außerdem denkbar, einen sich auflösenden Platzhalter (z.B. Fasern oder ähnliches) in das Klebeband B einzubringen.

So würden Kanäle geschafft werden, in denen sich der flüssige Klebstoff der Kapseln K1 ausbreiten und über einen großen Bereich innerhalb des Klebebandes B vernetzen kann.

Eine weitere Möglichkeit wäre die flüssig gefüllten Kapseln K1 in Röhrchen zu füllen und diese im Klebeband B einzubringen.

So könnte eine Vernetzung im Ausmaß der Röhrchenlänge stattfinden.

Dieses Grundprinzip kann auch auf ein Zweikomponentensystem wie in **Fig. 12B** dargestellt, ausgeweitet werden.

Hier wird der Inter- und Intravernetzungsmechanismus verwendet.

Zusätzlich zu den ersten Kapseln K1 des Einkomponentensystems wird eine zweite Kapselpopulation K2 eingeführt.

Dieser Mechanismus ermöglicht ein Zweikomponenten-Klebesystem in einem Klebeband B einzuführen.

Die beschriebenen Systeme sind nicht auf Einkomponenten-Kapselsysteme oder Zweikomponenten-Kapselsysteme beschränkt.

Abhängig von der Größe und Funktionalisierung des jeweiligen Systems können beliebig viele Kapselpopulationen Kn aneinandergebunden und untereinander vernetzt werden.

Durch Kombination der einzelnen Komponenten kann ein sehr breites Spektrum an neuen Funktionsweisen und somit neuen Anwendungsmöglichkeiten entwickelt werden.

Im Folgenden wird exemplarisch die Herstellung von Polymethylmethacrylat Mikrokapseln beschrieben:
Zunächst werden 2,5 g Polymethylmethacrylat (PMMA) in 11,5 ml Toluol gelöst. Anschließend wird Öl eingerührt. Für die Mikroverkapselung wird die homogene Lösung in 45 ml einer 1 Gewichts-%igen Polyvenylalkohol (PVA) Lösung gegeben. Die Emulsion wird mit 800 U/min für 30 min gerührt. Anschließend wird das Toluol verdampft. Die so erhaltenen Mikrokapseln K mit einem PMMA Coating-Material werden mit destilliertem Wasser gewaschen und bei 5.000 U/min zentrifugiert und über Nacht bei 50 °C in einem Vakuumofen getrocknet.

Dann wird die Oberfläche der Mikrokapseln silanisiert. Die Mikrokapseln werden in einen Wirbelschichtreaktor gegeben. Als Coating-Material wird eine 5 %ige, wässrige (3-Aminopropyl)triethoxysilane (APTES) Lösung verwendet. Nach dem Coatingprozess werden die Mikrokapseln für 1h bei 80 °C im Vakuumofen getrocknet, um eine optimale Anbindung des Aminosilans an die Oberfläche zu erhalten. Zusätzlich kann vor der Reaktion die Oberfläche der Mikrokapseln K mit Sauerstoffplasma aktiviert werden.

Für die Intervernetzung zweier Kapselpopulationen K1 und K2 (Kapseln K mit unterschiedlichem Inhalt), kann die komplementäre Kapselpopulation K mit CarboxylGruppen funktionalisiert werden. Hier ist das Vorgehen analog zu der oben beschriebenen Silanisierung. Jedoch wird anstatt des (3-Aminopropyl)triethoxysilane (APTES) ein Silan-PEG-COOH verwendet.

Anschließend können die Kapseln K noch mit einem Sieb mit unterschiedlicher Porengröße gesiebt werden, um die Monodispersität zu erhöhen. Dies hat den Vorteil, dass im späteren Bindungsprozess die Volumenverhältnisse der beiden Kapselinhalte über die Größe der Kapseln K genau bestimmt werden kann.

Dann erfolgt die Mikrokapselbindung. Die erste Mikrokapsel K1 ist mit primären Aminen funktionalisiert, während die zweite Mikrokapsel K2 mit Carboxylgruppen funktionalisiert ist. Im nächsten Schritt werden 80µl einer 10%igen Carboxylfunktionaliserten Mikrokapselsuspension in eine wässrigen Lösung gegeben und 7µL einer 2M (1-Ethyl-3-(3-dimethylaminopropyl)carbodiimid)-Lösung (EDC-Lösung) und 7µL einer 0,3M N-Hydroxysuccinimid)-Lösung (NHS-Lösung) hinzugegeben und eine Stunde bei Raumtemperatur gerührt. Die Carboxylfunktion wird zum Aktivester umgesetzt. Anschließend werden im selben Verhältnis wie die Carboxyl-Mikrokapseln K2 die Amin-Mikrokapseln K1 in die Lösung hinzugegeben und zwei Stunden bei Raumtemperatur und leichtem Rühren aneinandergebunden. Anschließend werden die Kapseln über ein Sieb abfiltriert, mit destilliertem Wasser gewaschen und im Vakuumofen eine Stunde bei 50 °C getrocknet.

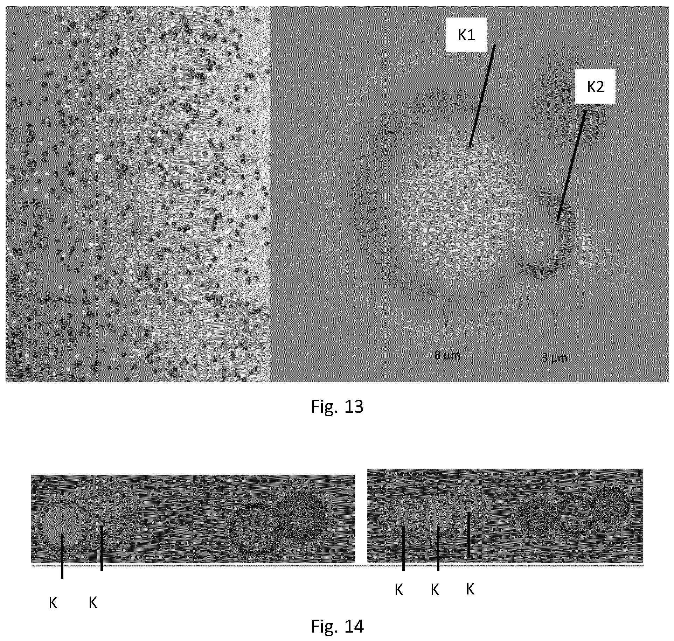

In **Fig. 13** ist zu erkennen, dass die meisten Mikrokapseln K im Verhältnis 1:1 aneinanderbinden.

Zudem gibt es ein paar Mikrokapseln K, die im Verhältnis 1:2 binden oder gar nicht aneinandergebunden haben.

Um die Qualität der Zweikomponenten-Mikrokapseln K sicher zu stellen werden die Mikrokapseln K anschließend über ein Sieb mit verschiedenen Porengrößen nach der Größe bzw. nach ihrem Bindungsverhältnis aufgereinigt. Über die Anzahl der funktionellen Gruppen an den Mikrokapseln K kann auch das Bindungsverhältnis der Mikrokapseln K beeinflusst werden.

Es ist möglich, dass Mikrokapseln K mit der gleichen Größe (z.B. 8µm) aber mit einer unterschiedlichen Funktionalisierung aneinandergebunden wurden. Bei der Funktionalisierung mit linearen Polymeren überwiegt die 1:1 Bindung, vgl. **Fig. 14****.** Bei einer Funktionalisierung mit Polymeren die eine Multivalenz aufweisen überwiegt die Dreifach-Bindung.

Es ist auch möglich, dass die Funktionalisierung von Mikrokapseln über Adsorption erfolgt.

Insbesondere bei Mikrokapseln mit Kunststoffoberflächen kann die Funktionalisierung von Mikrokapseln über Adsorption erfolgen. Bevorzugte Beispiele für Kunststoffoberflächen sind Acrylharz, Polymilchsäure, Nylon 6 und 12, Epoxidharze sowie Polystyrol.

Für die Adsorption an die Oberfläche der Mikrokapseln werden bevorzugt Alkylketten oder primäre Amine verwendet.

Die zweite funktionelle Gruppe kann frei gewählt werden und steht somit im nächsten Schritt für die Bindung der Mikrokapseln zur Verfügung.

Die Kunststoffoberfläche der Mikrokapseln kann direkt im Mikroverkapselungsverfahren entstehen oder in einem zweiten Schritt durch eine so erhaltene Multischichtmikrokapsel.

In einem alternativen Ausführungsbeispiel kann die zweite Mikrokapselpopulation mit Metallpartikeln bzw. einer Metallhülle hergestellt und/oder beschichtet werden.

Die beiden Mikrokapselpopulationen mit 4-aminobenzenthiol als Binder beider Mikrokapselpopulationen werden hinzugegeben.

Das primäre Amin bindet über Adsorption an die Mikrokapseln mit der Kunststoffoberfläche, die Thiolgruppe bindet an die Metalloberfläche.

Ferner ist eine Funktionalisierung während des Mikrokapselprozesses wie in WO2017192407 beschrieben möglich.

Demnach wird beispielsweise eine Mischung, welche Wasser (20 ml), Ethylacetat (5 ml), Natriumhydrogencarbonat (0,580 g), etwa 1,0 mg Sudan Black und einen Tropfen Tween 20 umfasst, bei Raumtemperatur unter Verwendung eines mechanischen Rührers (etwa 500 ml) kräftig gemischt (5 Minuten bei 500 rpm). Dem Gemisch werden 77 mg 1,3-Bischlorsulfonylbenzol zugesetzt, worauf für etwa 3 Minuten gerührt wird. Die Mischung wird dann mit 3,5-Diaminobenzoesäure behandelt und weitere 72 Stunden kräftig gerührt. Um die in der Mischung stattfindende Reaktion zu beobachten, werden dreißig Minuten nach Beginn des kräftigen Rührens, sowie danach in Intervallen von 12 Stunden Aliquots entnommen. Bei mikroskopischer Beobachtung zeigen die Aliquots eine Bildung Kapseln mit einem Durchmesser von 1 bis 2 Mikrometern, mit dem darin enthaltenen Farbstoff Sudan-Schwarz. Die Reaktion ist nach einigen Stunden beendet. Es wird postuliert, dass die Kapseln mehrere - COOH-Gruppen auf der Oberfläche haben.

Ferner ist eine Funktionalisierung während des Mikrokapselprozesses nach den weiteren in WO2017192407 beschrieben Verfahren möglich.

Demnach kann eine zweite Stoffportion in einem separaten Batch Ansatz nach derselben Methode, nur mit primären Aminen auf der Oberfläche hergestellt werden.

Anschließend kann die Mikrokapselpopulation mit COOH auf der Oberfläche wie im Beispiel zuvor mit EDC/ NHS aktiviert werden, die Amin-Kapselpopulation wird hinzugegeben werden und die Kapseln binden kovalent aneinander. Im nächsten Schritt können die Kapseln gewaschen, (ggf. filtriert) und getrocknet werden. Die so enthaltenen Kapseln können dann in einem weiteren Umgebungsmedium eingearbeitet werden.

Eine weitere denkbare Herstellungsmethode ist beispielsweise in Yip, J and Luk, MYA, Antimicrobial Textiles, Woodhead Publishing Series in Textiles, 2016, Pages 19-46, 3-Microencapsultion technologies for antimicrobial textiles, beschrieben.

Denkbar ist, dass die Mikrokapseln mit Metallpartikeln auch über Ladung aufgebracht werden können.

Eine Intravernetzung ist möglich.

Denkbar ist, dass nach der Herstellung der Mikrokapseln mit Metallpartikeln auf der Oberfläche ein Gemisch aus Alkohol und Mercaptane (SAM-Polymer) zu den Kapseln hinzugegeben wird.

Bei funktionalisierten Thiolen kann die zweite funktionelle Gruppe beliebig gewählt werden. Die Thiolbindungen binden an der Metalloberfläche. Der Rest, also die zweite funktionelle Gruppe des Thiolmoleküls, steht als funktionelle Gruppe für die Mikrokapselbindung zur Verfügung.

Durch Wahl einer oder mehrerer SAM Polymere, die zu den Mikrokapseln hinzugegeben werden, können die funktionellen Gruppen der Oberfläche homogen oder heterogen ausgestaltet werden.

Zudem kann die Länge des Linkers durch ein geeignetes Mercaptane bestimmt werden.

In einem Ausführungsbeispiel ist es möglich, für einen kurzen Linker Ethanethiol zu wählen. Für einen längeren Linker kann ein 11-Mercaptoundecannoic gewählt werden.

Ferner besteht die Möglichkeit, die so funktionalisierte Oberfläche der Mikrokapseln mit einem zweiten Polymer, z.B. mit einem PEG zu binden, um so die Länge des Linkers weiter zu erhöhen.

Als SAM Oberfläche können Disulfite, Phosphorsäuren, Silane, Thiole und Polyelectrolyte verwendet werden. Insbesondere können Acetylcystein, Dimercaptobernsteinsäure, Dimercaptopropansulfonsäure, Ethanthiol (Ethylmercaptan), Dithiothreitol (DTT), Dithioerythritol (DTE), Captopril, Coenzym, A, Cystein, Penicillamin, 1-Propanthiol, 2-Propanthiol, Glutathion, Homocystein, Mesna, Methanthiol (Methylmercaptan) und/oder Thiophenol verwendet werden.

Eine Intervernetzung ist möglich.

Die Mikrokapseln mit den Metallnanopartikeln können wie oben beschrieben hergestellt werden.

Anschließend kann ein Gemisch aus Alkohol und Dithioether hinzugeben werden.

Die eine funktionelle Gruppe R ist geschützt.

So werden die Mikrokapseln funktionalisiert.

Über die Anzahl an Metallnanopartikels, die sich auf der Oberfläche der Mikrokapseln befinden, kann dann die Anzahl, bzw. die Dichte der Funktionalisierung und somit die Anzahl an funktionellen Gruppen bestimmt werden. Damit ist eine Bestimmung der Anzahl an Mikrokapseln K2, die miteinander über Intra- oder Intervernetzung miteinander reagieren, möglich.

Im nächsten Schritt können die Mikrokapseln in das gewünschte Umgebungsmedium eingebracht werden, wie z.B. in einen Haftklebstoff (oder dergleichen).

Für Intervernetzung ist die Verwendung von 4-Isocyanat Butan-1-Thiol denkbar, wobei die NCO-Gruppen geschützt sind.

Die Entfernung der Schutzgruppen und somit die Aktivierung der funktionellen Gruppen R erfolgt hier in dem noch niedrig viskosen Haftklebstoff. Die so freiwerdenden NCO-Gruppen können in wässriger Umgebung (z.B. dem Lösemittel des Haftklebstoffes) untereinander zu Harnstoff vernetzen.

### Bezugszeichen

- B: Klebeband
- C: Kern, Core
- K: Kapsel/Kapselpopulation
- K1: Kapsel 1/Kapselpopulation 1
- K2: Kapsel 2/Kapselpopulation 2
- K3: Kapsel 3/Kapselpopulation 2
- Kn: Kapsel n/Kapselpopulation n
- KG: Gaskapsel
- L: Linker
- L1: Linker 1
- L2: Linker 2
- R: funktionelle Gruppe
- R1: funktionelle Gruppe 1
- R2: funktionelle Gruppe 2
- R21: funktionelle Gruppe 21
- S: Kapsel, Shell
- S1: Schritt 1
- S2: Schritt 2
- S3: Schritt 3
- S4: Schritt 4
- SG: Schutzgruppe

## Patentansprüche

1. Mehrkomponentensystem mit wenigstens einem ersten Stoff und mit wenigstens einem zweiten Stoff, wobei das Mehrkomponentensystem aktivierbar ist, wobei der erste Stoff und der zweite Stoff in mehreren Stoffportionen vorliegt, wobei die ersten Stoffportionen mit wenigstens einer ersten funktionellen Gruppe (R2) ausgebildet und einem ersten Linker (L1) versehen sind und wobei die zweiten Stoffportionen mit wenigstens einer zweiten funktionellen Gruppe (R21) ausgebildet und einem zweiten Linker (L2) versehen sind, wobei die erste funktionelle Gruppe (R2) über eine vordefinierte Wechselwirkung mit der zweiten funktionellen Gruppe (R21) reagiert und diese miteinander verbindet und wobei der Abstand der funktionellen Gruppen zu der jeweiligen Stoffportion durch den jeweiligen Linker (L) bestimmt ist.

2. Mehrkomponentensystem nach Anspruch 1, **dadurch gekennzeichnet, dass** der erste Linker (L1) länger als der zweite Linker (L2) ist oder umgekehrt.

3. Mehrkomponentensystem nach Anspruch 1 oder Anspruch 2, **dadurch gekennzeichnet, dass** die ersten Stoffportionen und die zweiten Stoffportionen sich dahingehend unterscheiden, dass die ersten Stoffportionen mit einer größeren Anzahl an Stoffportionen verbunden sind bzw. verbindbar sind als die zweiten Stoffportionen oder umgekehrt.

4. Mehrkomponentensystem nach einem der vorhergehende Ansprüche, **dadurch gekennzeichnet, dass** die funktionellen Gruppen (R) homogen oder heterogen ausgebildet sind.

5. Mehrkomponentensystem nach einem der vorhergehende Ansprüche, **dadurch gekennzeichnet, dass** die ersten Stoffportionen eine im Wesentlichen identische Größe aufweisen und/oder dass die zweiten Stoffportionen eine im Wesentlichen identische Größe aufweisen.

6. Mehrkomponentensystem nach einem der vorhergehende Ansprüche, **dadurch gekennzeichnet, dass** die ersten Stoffportionen und die zweiten Stoffportionen eine unterschiedliche Größe aufweisen.

7. Mehrkomponentensystem nach einem der vorhergehende Ansprüche, **dadurch gekennzeichnet, dass** das Mehrkomponentensystem eine Netzwerkstruktur mit Zwischenräumen aufweist, wobei die Netzwerkstruktur von Stoffportionen des ersten Stoffes ausgebildet ist, wobei in den Zwischenräumen zumindest abschnittsweise je wenigstens eine Stoffportion des zweiten Stoffes angeordnet ist.

8. Mehrkomponentensystem nach einem der vorhergehende Ansprüche, **dadurch gekennzeichnet, dass** eine Stoffportion des ersten Stoffes und/oder des zweiten Stoffes in einer Kapsel (K), insbesondere einer Nanokapsel und/oder Mikrokapsel angeordnet ist.

9. Mehrkomponentensystem nach einem der vorhergehende Ansprüche, **dadurch gekennzeichnet, dass** eine Kapsel (K1) für den ersten Stoff eine andere Größe aufweist als eine Kapsel (K2) für den zweiten Stoff, insbesondere wobei die Kapsel (K1) für den ersten Stoff größer ist als die Kapsel (K2) für den zweiten Stoff.

10. Mehrkomponentensystem nach Anspruch 8 oder Anspruch 9, **dadurch gekennzeichnet, dass** die Kapseln (K1) für den ersten Stoff eine identische Größe aufweisen.

11. Mehrkomponentensystem nach einem der vorhergehende Ansprüche, **dadurch gekennzeichnet, dass** die Aktivierung des Mehrkomponentensystems durch wenigstens eine Änderung von Druck, pH-Wert, UV-Strahlung, Osmose, Temperatur, Lichtintensität, -Feuchtigkeit oder dergleichen erfolgt.

12. Mehrkomponentensystem nach einem der vorhergehende Ansprüche, **dadurch gekennzeichnet, dass** der erste Stoff und der zweite Stoff Bestandteile eines Mehrkomponentenklebstoffes, insbesondere Zweikomponentenklebstoffes, sind.

13. Verfahren zur Herstellung eines Mehrkomponentensystems mit wenigstens einem ersten Stoff und mit wenigstens einem zweiten Stoff, wobei der erste Stoff und der zweite Stoff in mehreren Stoffportionen vorliegt, wobei das Mehrkomponentensystem aktivierbar ist, umfassend die folgenden Schritte:
- die ersten Stoffportionen werden mit wenigstens einer ersten funktionellen Gruppe ausgebildet (R2) und mit einem ersten Linker (L1) versehen,
- die zweiten Stoffportionen werden mit wenigstens einer zweiten funktionellen Gruppe (R21) ausgebildet und mit einem zweiten Linker (L2) versehen,
- die erste funktionelle Gruppe (R2) reagiert über eine vordefinierte Wechselwirkung mit der zweiten funktionellen Gruppe (R21), so dass diese miteinander verbunden werden, und
der Abstand der funktionellen Gruppen (R2, R21) zu der jeweiligen Stoffportion wird durch den jeweiligen Linker (L) bestimmt.

14. Verfahren nach Anspruch 13, **dadurch gekennzeichnet, dass** die ersten Stoffportionen mit wenigstens einer dritten funktionellen Gruppe (R1) ausgebildet und mit einem dritten Linker (L3) versehen sind, wobei die dritte funktionelle Gruppe (R1) jeweils wenigstens eine Schutzgruppe (SG) aufweist, so dass an die Stoffportionen des ersten Stoffes nur entsprechend funktionalisierte Stoffportionen des ersten Stoffes binden können, und wobei das Verfahren weiter wenigstens den Schritt umfasst, dass die Schutzgruppen (SG) zunächst vorliegen und erst dann entfernt werden, wenn die ersten Stoffportionen mittels der dritten funktionellen Gruppen (R1) miteinander verbunden werden sollen.

15. Verfahren nach Anspruch 13 oder Anspruch 14, **dadurch gekennzeichnet, dass** das Mehrkomponentensystem ein Mehrkomponentensystem nach einem der Ansprüche 1 bis 12 ist.
